Europäisches Patentamt

European Patent Office

Office européen des brevets

(19)

(11) Publication number: **0 288 221 B1**

(12) **EUROPEAN PATENT SPECIFICATION**

(45) Date of publication of patent specification :
25.09.91 Bulletin 91/39

(51) Int. Cl.⁵ : **C30B 7/10, C30B 29/10**

(21) Application number : 88303407.6

(22) Date of filing : 15.04.88

(54) Method of manufacturing calcium carbonate single crystals.

(30) Priority : 23.04.87 JP 100470/87
13.10.87 JP 257762/87

(43) Date of publication of application :
26.10.88 Bulletin 88/43

(45) Publication of the grant of the patent :
25.09.91 Bulletin 91/39

(84) Designated Contracting States :
DE FR GB

(56) References cited :
EP-A- 0 209 209
JOURNAL OF CRYSTAL GROWTH; vol, 79(1),
no's. 1-3, 2nd December 1986, pages 223-226,
Elsevier Science Publishers B.V.(North-Hol-
land Physics Publishing Division) Amsterdam,
NL; S. HIRANO et al.: "Solubility and
hydrothermal growth of calcite single crystal
in nitrate solutions"
JOURNAL OF CRYSTAL GROWTH, vol. 38, no.
1, April 1977, pages 29-37, North-Holland Pub-
lishing Co., Amsterdam, NL; F. LEFAUCHEUX
et al.: "Defects revealing the two growth pro-
cesses for a face case of hydrothermal synth-
etic calcite"

(73) Proprietor : SHINICHI HIRANO
123, Meidai Yada-cho Shukusha 66, Yada-cho
2-chome Higashi-ku
Nagoya-shi Aichi (JP)
Proprietor : SEIKO INSTRUMENTS INC.
31-1, Kameido 6-chome Koto-ku
Tokyo 136 (JP)

(72) Inventor : Hirano, Shinichi Room No. 123
Nagoya Univ.
Yadacho Apt. 66 Yadacho 2-chome Higashi-ku
Nagoya-shi Aichi-ken (JP)
Inventor : Kuroda, Hiroshi c/o Seiko
Instruments Inc.
31-1 Kameido 6-chome Koto-ku
Tokyo (JP)
Inventor : Toyokuni, Ryo c/o Seiko Instruments
Inc.
31-1 Kameido 6-chome Koto-ku
Tokyo (JP)

(74) Representative : Miller, Joseph et al
J. MILLER & CO. Lincoln House 296-302 High
Holborn
London WC1V 7JH (GB)

## Description

This invention relates to methods of manufacturing calcium carbonate single crystals (calcite) widely used for optical polarizers, etc.

Single crystals of calcium carbonate ($CaCO_3$) are suitable for optical uses and, for this purpose, natural calcite crystals are currently used. Calcite single crystals exhibit double refraction of incident light. Calcite has a high refractive index and is used as a polarizing prism in optical apparatus. Because of recent advances in the design of apparatus such as laser optics and optical communication apparatus, there is an increased demand for a material with excellent optical characteristics. In this regard, calcite single crystals are an ideal material, and are expected to be more and more in demand.

Calcite single crystals have been obtained only from natural sources because they have not yet been industrially synthesized. For commercial use, natural calcite must be colourless and transparent, must have no bubbles or cracks, no twining and no internal strains, and must be larger than a certain size. However, calcite single crystals that will meet this requirement are found only in limited quantities in the Republic of South Africa, Mexico, etc., and reserves are running low.

There have been experiments to synthesize calcium carbonate single crystals. One method is crystallization from a solvent, another is the synthesizing from a flux, a third is crystallization from a flux or melt, a fourth is hydrothermal synthesis, and recently an FZ method under high pressure has been suggested. However, optical characteristics such as transparency of resultant crystals have not been entirely satisfactory due to defects such as impurities, mixing, dislocations, inclusions or internal strains.

Among the methods tried for the manufacture of calcium carbonate single crystals, hydrothermal synthesis is most similar to the process by which natural calcite is grown as a hydrothermal ore deposit. Therefore, hydrothermal synthesis can produce a desired calcium carbonate single crystal with characteristics similar to natural calcite.

The hydrothermal synthesis process for manufacturing calcium carbonate single crystals utilises an aqueous solvent held at a predetermined temperature and pressure in an autoclave. Alkaline aqueous solutions such as sodium hydroxide (NaOH) or alkali carbonate aqueous solutions such as sodium carbonate ($Na_2CO_3$), potassium carbonate ($K_2CO_3$), etc. are generally used as the aqueous solvent. This method of growth of calcium carbonate single crystals is essentially a modification of conventional growth technology for artificial crystals. Under the following conditions :

| | |
|---|---|
| Solvent | — 6 mol $K_2CO_3$ aqueous solution |
| Temperature | — 410° to 445°C |
| Pressure | — 1720 atmospheres |
| Growth speed | — 50 μm/day |

about 3 mm growth layer of a calcium carbonate single crystal has been obtained.

The hydrothermal synthesis described above is disclosed by D.R. Kinlock H, R.F. Belt, R.C. Puttbac H, Journal of Crystal Growth 24/25 (1974) 610-613.

EP-A-0209209 discloses a method of manufacturing calcium carbonate single crystals grown by hydrothermal synthesis using a chloride aqueous solution and EP-A-0223473 discloses a method of manufacturing calcium carbonate single crystals grown by hydrothermal synthesis using an alkalinitrate aqueous solution, e.g any one of sodium nitrate, potassium nitrate and lithium nitrate.

Calcium carbonate crystals can be grown from an alkali carbonate aqueous solution by hydrothermal synthesis as described above, but there are problems. Firstly, due to the high concentration of solvent, inclusions frequently occur in the resultant crystals. These inclusions will result in inferior optical characteristics. Next, due to a high concentration of solvent, it is impossible to achieve sufficient pressure for quantitative production. In other words, the higher the solvent concentration, the lower the obtained pressure becomes even with the same filling-up rate. In the case of a 6 mol concentration of $K_2CO_3$ aqueous solution at 445°C and a filling-up rate of nearly 100%, it is impossible to obtain a pressure of 1720 atmospheres. Due to this, it is necessary to apply additional pressure from outside the autoclave thereby causing the apparatus and pressure system etc. to be complicated. Using an alkali carbonate aqueous solution, the growth speed will be very slow, i.e. 50 μm/day and therefore it will take more or less a year to grow crystals large enough to be used as optical elements.

The present invention seeks to provide a relatively simple method of manufacturing relatively quickly excellent calcium carbonate single crystals with good optical characteristics.

According to the present invention there is provided a method of manufacturing calcium carbonate single crystals wherein the calcium carbonate single crystal is grown by hydrothermal synthesis which applies heat and pressure to a starting material composed of calcium carbonate crystal within a solvent, characterised by using an ammonium nitrate aqueous solution as the solvent.

The temperature of the synthesis may be higher than 100°C, preferably in the range of 100°C to 360°C.

The ammonium nitrate aqueous solution may have a molarity of from 0.01 to 3.

Said pressure is preferably less than 1000 kg/cm² and may be in the range of 20 to 300 kg/cm².

The calcium carbonate single crystal may be deposited on the inside surface of a pressure vessel.

Alternatively, the calcium carbonate single crystal may be grown on a seed crystal.

The invention is illustrated, merely by way of example, in the accompanying drawings, in which :

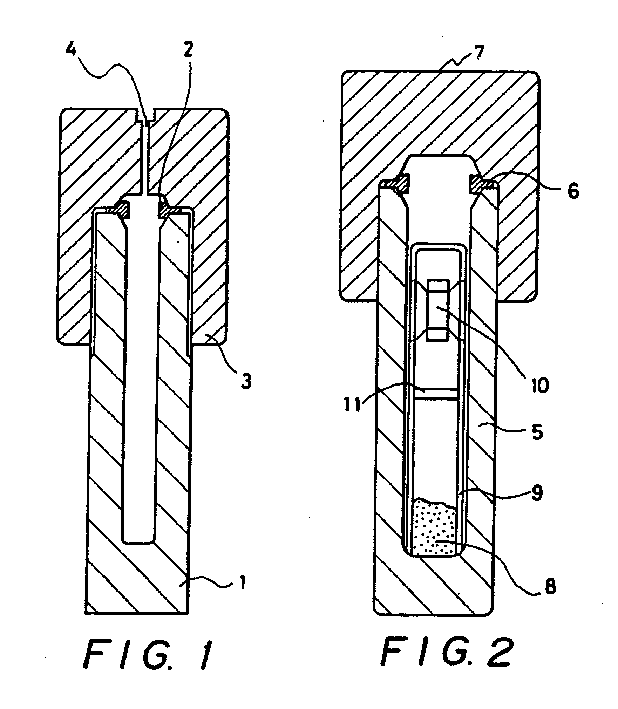

Figure 1 is a sectional view of a test tube used in Example 1 according to the present invention ; and

Figure 1 is a sectional view of a pressure vessel used in Example 2 according to the present invention.

The problems encountered in growing calcium carbonate single crystals by the prior art hydrothermal synthesis technique, namely, inferior optical quality, complicated apparatus, and long growth period, etc. result from having to use a high concentration solvent and high pressure. In other words, the problems stem from the choice of solvent and growth conditions.

An ammonium nitrate aqueous solution has been found best to avoid these problems, from amongst various kinds of existing solvents such as alkaline, carbonate, acid and chloride solutions.

In the present invention, hydrothermal synthesis initiating material is dissolved in a suitable aqueous solution of solvent at an appropriate temperature and pressure, and crystallization on a substrate is effected by gradual cooling or by transporting nourishment (material) through a temperature differential. The solvent should, therefore, be such that the starting material dissolves well in it and it should have little corrosive action on the apparatus used. An ammonium nitrate aqueous solution as a solvent has been found to be ideal.

The invention is further described with reference to the following Examples.

## EXAMPLE 1

A starting material, commercially available calcium carbonate of high purity is used. For hydrothermal synthesis an autoclave test tube of stellite quality No. 25 was used. Figure 1 shows the structure of the test tube having a pressure vessel body 1 with a cover 3 and a seal 2.

The inside of the pressure vessel body was measured through a temperature measuring hole 4. A gold capsule, 3 mm-5 mm in diameter was placed in the test tube. The starting material and solvent were poured into the test tube for hydrothermal synthesis. In this case, the pressure between the inside and the outside of the capsule was balanced by filling the inside of the pressure vessel with distilled water.

The result using various solvents and the result of growing crystals using each solvent and the condition of the hydrothermal synthesis are shown in the following Table I :

Table I

| Hydrothermal synthesis conditions | | | Size* of crystal obtained mm |
|---|---|---|---|
| solvent | temperature [°C] | pressure [kg/cm²] | |
| 3 Mol NaNO$_3$ | 300 | 750 | 0.2 - 0.3 |
| 3 Mol NaNO$_3$ | 300 | 750 | 0.2 - 0.3 |
| 3 Mol NaNO$_3$ | 370 | 750 | 0.3 - 0.5 |
| 3 Mol NaNO$_3$ | 420 | 500 | 0.1 - 0.2 |
| 3 Mol NaNO$_3$ | 450 | 750 | 0.8 - 1.0 |
| 3 Mol NaNO$_3$ | 500 | 750 | 1.0 - 1.2 |
| 3 Mol KNO$_3$ | 400 | 750 | 0.5 - 0.6 |

| 3 Mol KNO$_3$ | 400 | 1000 | 0.6 - 0.8 |
|---|---|---|---|
| 3 Mol LiNO$_3$ | 380 | 750 | 0.3 - 0.5 |
| 3 Mol LiNO$_3$ | 420 | 750 | 0.6 - 1.0 |
| 3.5 Mol Ca(NO$_3$)$_2$ | 180 | 1000 | not grown |
| 3.5 Mol Ca(NO$_3$)$_2$ | 200 | 750 | 0.1 - 0.2 |
| 4.0 Mol Ca(NO$_3$)$_2$ | 240 | 750 | 0.3 - 0.4 |
| 3.5 Mol Ca(NO$_3$)$_2$ | 280 | 1000 | 0.3 - 0.5 |
| 3.0 Mol Ca(NO$_3$)$_2$ | 320 | 800 | 0.4 - 0.5 |
| 3.5 Mol Ca(NO$_3$)$_2$ | 360 | 750 | 0.6 - 0.7 |
| 3.5 Mol Ca(NO$_3$)$_2$ | 400 | 1000 | 0.8 - 1.0 |

| | | | |
|---|---|---|---|
| 3.0 Mol Ca(NO$_3$)$_2$ | 440 | 750 | 0.8 – 1.2 |
| 1.0 Mol NH$_4$NO$_3$ | 100 | 1000 | not grown |
| 1.0 Mol NH$_4$NO$_3$ | 120 | 1000 | 0.2 |
| 1.0 Mol NH$_4$NO$_3$ | 140 | 1000 | 0.4 – 0.6 |
| 0.8 Mol NH$_4$NO$_3$ | 170 | 1000 | 0.6 – 1.0 |
| 0.8 Mol NH$_4$NO$_3$ | 200 | 1000 | 0.8 – 1.2 |
| 0.5 Mol NH$_4$NO$_3$ | 240 | 750 | 0.8 – 1.1 |
| 0.5 Mol NH$_4$NO$_3$ | 280 | 750 | 0.9 – 1.2 |
| 0.5 Mol NH$_4$NO$_3$ | 320 | 1000 | 1.0 – 1.4 |
| 0.5 Mol NH$_4$NO$_3$ | 360 | 750 | 1.2 – 1.5 |

| | | | |
|---|---|---|---|
| 0.5 Mol NH$_4$NO$_3$ | 100 | 1000 | 0.2 |
| 0.5 Mol NH$_4$NO$_3$ | 120 | 1000 | 0.3 |
| 0.1 Mol NH$_4$NO$_3$ | 150 | 1000 | 0.3 |
| 0.02 Mol NH$_4$NO$_3$ | 170 | 1000 | 0.2 |
| 0.01 Mol NH$_4$NO$_3$ | 200 | 1000 | 0.2 |
| 0.01 Mol NH$_4$NO$_3$ | 240 | 800 | 0.3 |
| 0.01 Mol NH$_4$NO$_3$ | 280 | 500 | 0.4 |
| 0.01 Mol NH$_4$NO$_3$ | 360 | 500 | 0.4 - 0.6 |
| 0.02 Mol NH$_4$NO$_3$ | 320 | 500 | 0.4 - 0.7 |
| 3.0 Mol NH$_4$NO$_3$ | 100 | 300 | 0.2 |

| | | | |
|---|---|---|---|
| 3.0 Mol NH$_4$NO$_3$ | 120 | 300 | 0.4 |
| 3.0 Mol NH$_4$NO$_3$ | 140 | 200 | 0.3 - 0.5 |
| 3.0 Mol NH$_4$NO$_3$ | 170 | 100 | 0.3 - 0.6 |
| 3.0 Mol NH$_4$NO$_3$ | 200 | 100 | 0.3 - 0.6 |
| 3.0 Mol NH$_4$NO$_3$ | 240 | 50 | 0.4 - 0.6 |
| 3.0 Mol NH$_4$NO$_3$ | 280 | 50 | 0.5 - 0.7 |
| 3.0 Mol NH$_4$NO$_3$ | 320 | 20 | 0.5 - 0.7 |
| 3.0 Mol NH$_4$NO$_3$ | 360 | 20 | 0.7 - 0.9 |

* All growth periods were 7 days.

As shown in the above Table I, it was found that crystals were grown by using any one of NaNO$_3$, KNO$_3$, LiNO$_3$, Ca(NO$_3$)$_2$ and NH$_4$NO$_3$ as the solvent.

In every case it was found that the crystals were grown using any one of NaNO$_3$, KNO$_3$, LiNO$_3$, Ca(NO$_3$)$_2$ and NH$_4$NO$_3$. However, as shown in Table I, when the hydrothermal synthesis was carried out using an ammonium nitrate (NH$_4$NO$_3$) aqueous solution, calcium carbonate single crystals can be grown under lower pressure and lower temperature, e.g. lower than 300 kg/cm$^2$ pressure and temperature in the range 100 to 360°C. In the case of NH$_4$NO$_3$ aqueous solution, the preferred temperature range of the hydrothermal synthesis is in the range 100 to 360°C. If the temperature is over 360°C, whilst it is possible to grow crystals there is the possibility of reduced quality and corrosion of the pressure vessel. As for the pressure, it is possible to grow crystals at pressures greater than 300 kg/cm$^2$ by selecting other hydrothermal synthesis conditions e.g. the concentration of the solvent and growth temperature. The NH$_4$NO$_3$ aqueous solution comprises preferably 0.01 to 3 mol aqueous solution of NH$_4$NO$_3$. It was identified by x-ray diffraction as in each case the crystals grown were calcium carbonate single crystals.

**EXAMPLE 2**

Figure 2 is a sectional view illustrating a typical test tube used in this Example. The test tube was made of stellite 25 as in Example 1. However, the inside of the test tube was lined with platinum in order to avoid contamination by pollutants. A pressure vessel body 5 was sealed with a cover 7 through a sealing ring 6. At the bottom of the pressure vessel 5, starting material 8 for the crystals to be grown was placed. The starting material was refined and re-crystallized in nitrate solvent according to the method of Example 1 and was powdered. A crystal support frame 9 carried thereon a species or seed crystal 10 over the starting material 8 at an upper portion of the pressure vessel. The seed crystal 10 was calcite with (0001) faces of natural optical grade. As the seed crystal, calcite with (1011) faces of natural optical grade may be used. It was necessary to choose a seed crystal with few internal inclusions, and little lattice displacement, etc., so that defects in the single crystal to be grown thereon may be avoided. A baffle 11 was provided between the starting material 8 and the seed crystal 10 to produce a temperature difference therebetween and was supported on the frame 9. The inside of the pressure vessel body 5 was filled up with nitrate aqueous solution, e.g. $NaNO_3$, $KNO_3$, $LiNO_3$, $Ca(NO_3)_2$ and $NH_4NO_3$, as a solvent at such a filling-up rate as to establish a predetermined temperature and pressure.

By using various solvents, the result of growing crystals for each solvent and the hydrothermal treatment are shown in the following Table II :

Table II

| Solvent | Temperature of seed crystal °C | Temperature of starting material °C | Pressure kg/cm² | Growth Period days | Thickness of grown layer or film mm | Growth rate μm/day |
|---|---|---|---|---|---|---|
| 3 Mol NaNO₃ | 370 | 420 | 750 | 50 | 6.6 | 132 |
| 3.5 Mol Ca(NO₃)₂ | 360 | 400 | 750 | 50 | 7.0 | 140 |
| 3.5 Mol Ca(NO₃)₂ | 280 | 320 | 750 | 50 | 3.8 | 76 |
| 3.5 Mol Ca(NO₃)₂ | 200 | 260 | 750 | 50 | 2.2 | 44 |
| 0.5 Mol NH₄NO₃ | 280 | 320 | 750 | 50 | 10 | 200 |
| 0.5 Mol NH₄NO₃ | 220 | 260 | 750 | 50 | 8.9 | 178 |
| 0.8 Mol NH₄NO₃ | 160 | 200 | 1000 | 50 | 8.6 | 172 |
| 3 Mol NH₄NO₃ | 280 | 320 | 20 | 50 | 7.3 | 146 |
| 3 Mol NH₄NO₃ | 220 | 260 | 50 | 50 | 7.6 | 152 |
| 3 Mol NH₄NO₃ | 160 | 200 | 100 | 50 | 7.0 | 140 |
| 0.01 Mol NH₄NO₃ | 280 | 320 | 500 | 50 | 6.5 | 130 |
| 0.01 Mol NH₄NO₃ | 220 | 260 | 800 | 50 | 5.5 | 110 |
| 0.02 Mol NH₄NO₃ | 160 | 200 | 1000 | 50 | 4.0 | 80 |

Characteristics of grown layer or film in each case was calcium carbonate single crystal identified by x-ray diffraction. Its optical characteristics was the same as that of natural calcite (with respect to permeability rate, compound refractive index, etc).

From the above discussion, it will be appreciated that it is easier for growth of calcium carbonate single crystals to be be industrialized by hydrothermal synthesis because a pressure less than 1000 kg/cm$^2$ is used and, at the same time, defects inside the grown crystals are reduced as compared with the prior art growth methods of calcium carbonate single crystals using alkali carbonate aqueous solutions.

The growth rate of the crystals is over twice that achieved by the prior art methods, and this is a very favourable feature from the point of view of industrialization. In the case of using $NH_4NO_3$ aqueous solution, $CaCO_3$ single crystals can be made industrially relatively easily because of growth at lower pressure and at lower temperature, e.g. lower than 300 kg/cm$^2$ pressure and temperature in the range of 100 to 360°C. It is thus possible for calcium carbonate single crystals of optical grade quality equal to that of natural calcite to be made industrially by the same technology as that for the current artificial crystals. To be able industrially to produce such calcium carbonate crystals equal in quality to natural optical grade calcite will mean that it will be possible always to provide the market with such crystals with consistent quality. Because of the dependence upon natural calcite, there has been no guarantee of either a regular supply or consistent quality. Industrialization of calcium carbonate single crystals will achieve such consistency and enhance their use in optical elements and parts etc. used in a whole range of apparatus and will enable their characteristics to be improved.

## Claims

1. A method of manufacturing calcium carbonate single crystals wherein the calcium carbonate single crystal is grown by hydrothermal synthesis which applies heat and pressure to a starting material composed of calcium carbonate crystal within a solvent, characterised by using an ammonium nitrate aqueous solution as the solvent.

2. A method as claimed in claim 1 characterised in that the temperature of the synthesis is higher than 100°C.

3. A method as claimed in claim 2 characterised in that said temperature is in the range of 100 to 360°C.

4. A method as claimed in any preceding claim characterised in that the ammonium nitrate aqueous solution has a molarity of from 0.01 to 3.

5. A method as claimed in any preceding claim characterised in that said pressure is less than 1000 kg/cm$^2$.

6. A method as claimed in claim 5 characterised in that said pressure is in the range of 20 to 300 kg/cm$^2$.

7. A method as claimed in any preceding claim characterised in that the calcium carbonate single crystal is deposited on the inside surface of a pressure vessel.

8. A method as claimed in any of claims 1 to 6 characterised in that the calcium carbonate single crystal is grown on a seed crystal.

## Patentansprüche

1. Verfahren zur Herstellung von Calciumcarbonat-Einkristallen, worin der Calciumcarbonat-Einkristall durch hydrothermale Synthese gezüchtet wird, wobei ein aus kristallinem Calciumcarbonat bestehendes Ausgangsmaterial mit Hitze und Druck behandelt wird, **dadurch gekennzeichnet**, daß man als Lösungsmittel eine wäßrige Ammoniumnitrat-Lösung verwendet.

2. Verfahren nach Anspruch 1, **dadurch gekennzeichnet**, daß die Temperatur der Synthese höher als 100°C ist.

3. Verfahren nach Anspruch 2, **dadurch gekennzeichnet**, daß die Temperatur im Bereich von 100 bis 360°C ist

4. Verfahren nach einem der vorhergehenden Ansprüche, **dadurch gekennzeichnet**, daß die wäßrige Ammoniumnitrat-Lösung eine Molarität von 0,01 bis 3 hat.

5. Verfahren nach einem der vorhergehenden Ansprüche, **dadurch gekennzeichnet**, daß der Druck geringer als 1000 kg/cm$^2$ ist.

6. Verfahren nach Anspruch 5, **dadurch gekennzeichnet**, daß der Druck im Bereich von 20 bis 300 kg/cm$^2$ ist.

7. Verfahren nach einem der vorhergehenden Ansprüche, **dadurch gekennzeichnet**, daß der Calciumcarbonat-Einkristall an der inneren Oberfläche eines Druckgefäßes abgeschieden wird.

8. Verfahren nach einem der Ansprüche 1 bis 6, **dadurch gekennzeichnet**, daß der Calciumcarbonat-Einkristall auf einem Impfkristall gezüchtet wird.

## Revendications

1. Un procédé de fabrication de monocristaux de carbonate de calcium, dans lequel on fait croître le monocristal de carbonate de calcium par une opération de synthèse hydrothermique qui applique de la chaleur et une pression à une matière de départ consistant en un cristal de carbonate de calcium dans un solvant, caractérisé par l'utilisation d'une solution aqueuse de nitrate d'ammonium à titre de solvant.

2. Un procédé selon la revendication 1, caractérisé en ce que la température de la synthèse est supérieure à 100°C.

3. Un procédé selon la revendication 2, caractérisé en ce que la température précitée est dans la plage de 100 à 360°C.

4. Un procédé selon l'une quelconque des revendications précédentes, caractérisé en ce que la solution aqueuse de nitrate d'ammonium a une molarité comprise entre 0,01 et 3.

5. Un procédé selon l'une quelconque des revendications précédentes, caractérisé en ce que la pression est inférieure à 100 MPa.

6. Un procédé selon la revendication 5, caractérisé en ce que la pression est dans la plage de 2 à 30 MPa.

7. Un procédé selon l'une quelconque des revendications précédentes, caractérisé en ce que le monocristal de carbonate de calcium est déposé sur la surface intérieure d'une enceinte sous pression.

8. Un procédé selon l'une quelconque des revendications 1 à 6, caractérisé en ce qu'on fait croître le monocristal de carbonate de calcium sur un cristal germe.

FIG. 1

FIG. 2